# EUROPÄISCHE PATENTSCHRIFT

(11) **EP 1 222 694 B1**
(45) Veröffentlichungstag und Bekanntmachung des Hinweises auf die Patenterteilung: **02.02.2005**
(21) Anmeldenummer: 00967552.1
(22) Anmeldetag: 11.09.2000
(51) Int. Cl.: H01L 29/872, H01L 29/47, H01L 29/45, H01L 29/24, H01L 21/329, H01L 21/04

(54) **SiC-Halbleitervorrichtung mit einem Schottky-Kontakt und Verfahren zu deren Herstellung**
SiC semiconductor device having a Schottky contact and method of making the same
Dispositif semi-conducteur en SiC à contact Schottky et sa méthode de fabrication

(30) Priorität: 22.09.1999 DE 19945453
(43) Veröffentlichungstag der Anmeldung: 17.07.2002
(73) Patentinhaber: SiCED Electronics Development GmbH & Co KG, 91052 Erlangen (DE)
(72) Erfinder: FRIEDRICHS, Peter, 90475 Nürnberg (DE); PETERS, Dethard, 91315 Höchstadt (DE); SCHÖRNER, Reinhold, 91091 Grossenseebach (DE)
(74) Vertreter: Berg, Peter, Dipl.-Ing.
(86) Internationale Anmeldenummer: PCT/DE2000/003147
(87) Internationale Veröffentlichungsnummer: WO 2001/022498

(56) Entgegenhaltungen:
- DE-C- 19 723 176
- US-A- 5 895 260
- CHILUKURI R K ET AL: "High voltage Ni/4H-SiC Schottky rectifiers" PROCEEDINGS OF THE 11TH INTERNATIONAL SYMPOSIUM ON POWER SEMICONDUCTOR DEVICES AND ICS (ISPSD'99), TORONTO, ONTARIO, CANADA, 26. - 28. Mai 1999, Seiten 161-164, XP002155179 IEEE, PISCATAWAY, NJ, USA ISBN: 0-7803-5290-4
- PORTER L M ET AL: "A critical review of ohmic and rectifying contacts for silicon carbide" MATERIALS SCIENCE & ENGINEERING B (SOLID-STATE MATERIALS FOR ADVANCED TECHNOLOGY), Bd. 34, Nr. 2-3, November 1995 (1995-11), Seiten 83-105, XP000627607 ELSEVIER SEQUOIA, LAUSANNE, CH ISSN: 0921-5107

## Beschreibung

Die Erfindung betrifft eine Halbleitervorrichtung aus Siliciumcarbid (SiC) mit einem Schottky-Kontakt und einem ohmschen Kontakt auf SiC-Halbleitergebieten mit zueinander entgegengesetzten Leitungstypen. Außerdem betrifft die Erfindung die Herstellung einer solchen Halbleitervorrichtung.

Aus der *US 4,641,174* ist eine Halbleitervorrichtung mit einem Schottky-Kontakt und einem ohmschen Kontakt bekannt. Es wird eine sogenannte Pinch-Gleichrichterdiode beschrieben, bei der mehrere Schottky-Dioden und mehrere p-n-Dioden in einem einzigen Halbleitersubstrat abwechselnd angeordnet und zueinander parallel geschaltet sind. Diese Anordnung zeichnet sich durch ein gutes Sperrverhalten aus, da die Raumladungszonen der p-n-Dioden die stromführenden Bereiche der Schottky-Dioden abschnüren und damit das Sperrvermögen der Schottky-Dioden verbessern. Da die Schottky- und die p-n-Dioden abwechselnd an derselben Oberfläche angeordnet sind, wird ein Kontakt benötigt, der einerseits ohmsches Verhalten auf einem stark p-leitenden Halbleitergebiet und andererseits Schottky-Verhalten auf einem schwach n-leitenden Halbleitergebiet aufweist. Für Halbleitergebiete aus Silicium wird Aluminium als in dieser Hinsicht geeignetes Kontaktmaterial genannt. Ein für Siliciumcarbid geeignetes Kontaktmaterial wird dagegen nicht angegeben.

In der *US 5,895,260* wird ein Verfahren zur Herstellung einer Schottky-Diode in n-leitendem SiC beschrieben. Eine erste Oberfläche des SiC-Halbleitergebiets wird zunächst mit einem dielektrischen Film bedeckt. Dann wird auf einer zweiten Oberfläche des SiC-Halbleitergebiets ein ohmscher Rückseitenkontakt in Form einer Nickel(Ni)-Schicht aufgebracht und bei einer Formierungstemperatur von 950°C formiert. Innerhalb eines anschließend freigelegten, bis zur ersten Oberfläche reichenden Kontaktfensters wird eine Schottky-Metallisierung aufgebracht. Als Metall für den Schottky-Kontakt wird nicht näher spezifiziertes Ti/Al oder Ni/Al verwendet. Da es sich bei der beschriebenen Halbleitervorrichtung um keine Pinch-Diode, sondern um eine einfache Schottky-Diode handelt, wird auch kein ohmscher Kontakt auf einem p-leitenden SiC-Halbleitergebiet offenbart.

Weiterhin wird auch mit der *US 5,270,252* sowie der *US 5,471,072* jeweils eine in n-leitendem β-SiC realisierte Schottky-Diode offenbart. Als Basismetall für den Schottky-Kontakt dient jeweils Platin (Pt). Ein ohmscher Kontakt wird durch einen Titan(Ti)/Gold(Au)-Schichtaufbau gebildet und vor Aufbringen des Schottky-Kontakts bei etwa 750°C formiert. Der Schottky-Kontakt und der ohmsche Kontakt kontaktieren dabei jeweils n-leitendes SiC.

Mit der *EP 0 380 340 A2* wird eine weitere, in n-leitendem α-SiC realisierte Schottky-Diode offenbart, bei der ebenfalls Platin (Pt) als wesentlicher Bestandteil der Schottky-Metallisierung dient. Eine Nickel (Ni)-Schicht wird als ohmsche Metallisierung auf die Rückseite aufgebracht und vor Aufbringen des Schottky-Kontakts bei etwa 1000°C formiert. Auch hier kontaktieren der Schottky-Kontakt und der ohmsche Kontakt jeweils n-leitendes SiC.

Aus der *US 5,929,523* ist außerdem ein Schottky-Kontakt aus Osmium (Os) auf n-leitendem Siliciumcarbid bekannt. Vor Aufbringen des Schottky-Kontakts wird der ohmsche Rückseitenkontakt hergestellt. Für den Schottky-Kontakt ist ein spezielles Herstellungsverfahren mit einem Prozessschritt, bei dem zunächst einige Monolagen Silicium auf die Oberfläche aufgesputtert werden, erforderlich. Der so hergestellte Schottky-Kontakt ist dann sehr temperaturstabil. Osmium ist ein Element, das zu den seltenen Erden gehört. Es ist ein schwer zu beschaffendes und auch teueres Element.

Weiterhin ist aus dem Fachaufsatz *"The Guard-Ring Termination for the High-Volta ge SiC Schottky Barrier Diodes", in IEEE Electron Device Letters, Vol. 16, No. 7, July 1995,* eine Halbleitervorrichtung mit einem Schottky-Kontakt auf einem n-leitenden SiC-Driftgebiet und mit einem sogenannten Guard-Ring aus p-leitendem SiC bekannt. Das n-leitende Driftgebiet und der p-leitende Guard-Ring sind mit einer gemeinsamen Kontaktschicht aus Al/Ti versehen. Dadurch soll der Guard-Ring ohmsch kontaktiert werden. Da der Guard-Ring wie üblich nur der elektrischen Feldführung in Sperrvorrichtung dient, und in Vorwärtsrichtung ausdrücklich eine Injektion von Minoritätsladungsträgern und damit ein Einschalten der zwischen dem Guard-Ring und dem Driftgebiet gebildeten p-n-Diode verhindert werden soll, wird aber kein hochwertiger ohmscher Kontakt zum Guard-Ring benötigt und auch nicht nacharbeitbar offenbart. Auch die niedrige p-Dotierung des Guard-Rings lässt nämlich den Rückschluss zu, dass der Kontakt zum Guard-Ring tatsächlich kein echtes ohmsches Verhalten aufweist.

In dem SiC-Übersichtsartikel *von J.B.Casady und R.W.Johnson in "Solid-State Electronics", Vol. 39, No.10, pp. 1409-1422, 1996,* hat ein Abschnitt die Schottky-Kontaktierung von SiC zum Thema. Demnach sind bisher Nickel (Ni), Nickelchrom (NiCr), Gold (Au), Platin (Pt), Titan (Ti), Magnesium (Mg), Kobalt (Co), Aluminium (A1), Hafnium (Hf) und Palladium (Pd) für einen Schottky-Kontakt auf SiC verwendet worden. Die Höhe der erzielbaren Schottky-Barriere hängt außer vom verwendeten Metall auch noch von der Oberflächenqualität des Siliciumcarbids, dem Abscheideverfahren, dem SiC-Polytyp, der Leitfähigkeit (n- oder p-leitend) und der Orientierung der SiC-Oberfläche (Si- oder C-Seite) ab. Es findet sich jedoch kein Hinweis auf einen in unmittelbarer Nachbarschaft zu dem Schottky-Kontakt angeordneten zusätzlichen ohmschen Kontakt auf einem SiC-Halbleitergebiet, das den gegenüber dem durch den Schottky-Kontakt kontaktierten SiC-Halbleitergebiet entgegengesetzten Leitungstyp aufweist.

In der *DE 197 23 176 C1* wird eine Pinch-Gleichrichterdiode aus SiC beschrieben, die ein erstes Halbleitergebiet aus n-leitendem Siliciumcarbid und ein zweites Halbleitergebiet aus p-leitendem Siliciumcarbid sowie eine Schottky-Kontaktschicht und eine ohmsche p-Kontaktschicht, die das erste bzw. zweite Halbleitergebiet elektrisch kontaktieren, umfasst. Mit den dort offenbarten Materialien lassen sich jedoch keine Kontaktschichten mit sowohl gutem Schottky-Kontaktverhalten als auch gutem ohmschen Kontaktverhalten erzielen.

Der Erfindung liegt nun die Aufgabe zugrunde, eine Halbleitervorrichtung mit einem guten Schottky-Kontakt auf einem n-leitenden SiC-Halbleitergebiet und mit einem guten ohmschen p-Kontakt auf einem p-leitenden SiC-Halbleitergebiet anzugeben. Der Schottky-Kontakt und der ohmsche p-Kontakt sollen dabei insbesondere unmittelbar benachbart zueinander liegen können. Außerdem soll ein einfaches und kostengünstiges Verfahren zur Herstellung einer solchen Halbleitervorrichtung angegeben werden.

Zur Lösung der die Halbleitervorrichtung betreffenden Aufgabe wird eine Halbleitervorrichtung entsprechend den Merkmalen des unabhängigen Patentanspruchs 1 angegeben.

Bei der erfindungsgemäßen Halbleitervorrichtung aus Siliciumcarbid mit einem Schottky-Kontakt und einem ohmschen p-Kontakt handelt es sich um eine Halbleitervorrichtung, welche mindestens
- ein erstes Halbleitergebiet aus n-leitendem Siliciumcarbid und ein zweites Halbleitergebiet aus p-leitendem Siliciumcarbid,
- eine Schottky-Kontaktschicht und eine ohmsche p-Kontaktschicht, die das erste bzw. zweite Halbleitergebiet elektrisch kontaktieren, die aus einem Material mit mindestens zwei Materialkomponenten bestehen umfasst, wobei das Material beider Kontaktschichten eine zumindest annähernd gleiche Zusammensetzung mit Nickel als erster Materialkomponente und Aluminium als zweiter Materialkomponente hat.

Zur Lösung der das Verfahren betreffenden Aufgabe wird ein Verfahren entsprechend dem Merkmal des unabhängigen Patentanspruchs 8 angegeben.

Bei dem erfindungsgemäßen Verfahren zur Herstellung einer Halbleitervorrichtung aus Siliciumcarbid mit einem Schottky-Kontakt und einem ohmschen p-Kontakt handelt es sich um ein Verfahren, bei welchem mindestens
- eine Schottky-Kontaktschicht auf einem ersten Halbleitergebiet aus n-leitendem Siliciumcarbid und eine ohmsche p-Kontaktschicht auf einem zweiten Halbleitergebiet aus p-leitendem Siliciumcarbid ausgebildet werden, indem
- für beide Kontaktschichten ein Material mit mindestens zwei Materialkomponenten, von denen Nickel eine erste Materialkomponente und Aluminium eine zweite Materialkomponente darstellen, die in den Kontaktschichten eine annähernd gleiche Materialzusammensetzung bilden.

Die Erfindung beruht dabei auf der Erkenntnis, dass durch die Auswahl des besonders günstigen Nickel-Aluminium-Materials die Herstellung einer Halbleitervorrichtung mit einem ohmschen p-Kontakt auf p-leitendem SiC und mit einem Schottky-Kontakt auf n-leitendem SiC wesentlich vereinfacht werden kann. Dies gilt insbesondere dann, wenn die beiden Kontakte unmittelbar benachbart zueinander liegen. Da das Nickel-Aluminium-Material außerdem zu sehr guten Kontakteigenschaften führt, ist eine mit diesem Kontaktwerkstoff hergestellte Halbleitervorrichtung besonders vorteilhaft. Das Kontaktmaterial kann dabei in Form eines Gemisches, eines Gemenges, einer Legierung oder einer Verbindung zumindest der Nickel- und der Aluminiumkomponente vorliegen.

Bisher werden der ohmsche p-Kontakt und der Schottky-Kontakt in getrennten Arbeitsschritten und insbesondere auch aus verschiedenen Kontaktmaterialien hergestellt. Da der zur Kontaktformierung des ohmschen p-Kontakts bei einer Formierungstemperatur von mindestens 900°C durchgeführte Temperprozess praktisch immer zu einer Degradation der elektrischen Eigenschaften eines mitgetemperten Schottky-Kontakts führt, wird der Schottky-Kontakt derzeit üblicherweise erst nach der ohmschen Kontaktformierung aufgebracht.

Diese sukzessive Herstellung des ohmschen p-Kontakts und des Schottky-Kontakts erfordert jedoch einen nicht unerheblichen Fertigungsaufwand. Insbesondere bei benachbarten Kontakten sind verschiedene Maskierungsschritte notwendig, um beide Kontaktschichten nach- und nebeneinander aufbringen zu können. Gegebenenfalls wird dabei auch die Oberfläche, auf die der Schottky-Kontakt aufgebracht werden soll, einer zusätzlichen Vorbehandlung unterzogen.

Durch die Verwendung des vorteilhaften Nickel-Aluminium-Materials entfallen die beschriebenen Prozessschritte, so dass sich der Herstellungsprozess erheblich verkürzt. Die Schottky-Kontaktschicht kann nämlich gemeinsam mit der ohmschen p-Kontaktschicht formiert werden, ohne dass es zu einer nennenswerten Degradation des Schottky-Kontaktverhaltens kommt. Diese günstige Eigenschaft erhält man nur, wenn das Material sowohl einen Nickel- als auch einen Aluminiumanteil enthält. Weder reines Nickel noch reines Aluminium weisen diesen Vorzug auf. Da die Oberfläche für den Schottky-Kontakt unmittelbar mit der endgültigen Schottky-Kontaktschicht bedeckt wird, ist auch keine zusätzliche Vorbehandlung erforderlich. Dies dient zum einen wiederum der Prozessökonomie und zum anderen trägt es auch zu einer verbesserten Qualität des Schottky-Kontakts bei.

Auch bei Aufbringen von gleichem Material auf das erste und zweite Halbleitergebiet ist es gegebenenfalls je nach gewählter SiC-Dotierung und je nach Zusammensetzung des verwendeten Materials möglich, dass sich zwischen den beiden Halbleitergebieten und den beiden Kontaktschichten jeweils ein Grenzbereich mit leicht voneinander abweichender Materialzusammensetzung einstellt. Diese geringfügige Abweichung rührt von unterschiedlichen Austauschvorgängen zwischen dem aufgebrachten Material und dem ersten oder dem zweiten Halbleitergebiet her.

So enthält das aufgebrachte Material mit dem Aluminium eine Materialkomponente, die in Siliciumcarbid als Akzeptor wirkt. Das Aluminium wird also in gewissem Umfang in das erste oder zweite Halbleitergebiet wandern und dort als Akzeptor an entsprechenden Gitterstellen eingebunden. Dieser Durchmischungsvorgang wird maßgeblich durch die ursprüngliche Dotierung des ersten oder zweiten Halbleitergebiets beeinflusst und verläuft somit im jeweiligen Grenzbereich unterschiedlich. Dadurch verändert sich der Aluminiumanteil in den jeweiligen Grenzbereichen in voneinander abweichendem, wenn auch sehr geringem Umfang.

Auch das silicidbildende Nickel führt zu einer gewissen Verschiebung der Materialzusammensetzung in den jeweiligen Grenzbereichen. In diesem Fall durchmischt sich Silicium, das aus dem ersten und zweiten Halbleitergebiet stammt, mit dem Nickel der beiden Kontaktschichten. Infolge bildet sich dann in beiden Grenzbereichen ein Nickelsilicid. Auch bei diesem Prozess sind Dotierungsgrad und Leitungstyp maßgebliche Einflussfaktoren, so dass dieser Effekt ebenfalls zu einer leicht voneinander abweichenden Materialzusammensetzung in den Grenzbereichen führen kann.

In den von den Grenzflächen entfernter lokalisierten Bereichen der beiden Kontaktschichten wirken sich die beschriebenen Grenzflächeneffekte nicht aus, so dass das Material in seiner ursprünglich aufgebrachten Zusammensetzung erhalten bleibt und sich somit in diesen Bereichen der jeweiligen Kontaktschicht gleicht.

Bei der erfingungsgemäßen Lehre werden alle geringfügigen Unterschiede in der Materialzusammensetzung der beiden Kontaktschichten wie die, die auf den beschriebenen oder ähnlichen Grenzflächeneffekten beruhen, nicht als maßgeblich betrachtet und unter den Begriffen "zumindest annähernd gleiche Materialzusammensetzung" und "praktisch homogen" subsumiert.

Außerdem werden Unterschiede in der Materialzusammensetzung, die auf übliche, gegebenenfalls unterschiedliche Verunreinigungen in Ausgangssubstanzen zurückzuführen sind, hier ebenfalls als nicht maßgeblich betrachtet.

Besondere Ausgestaltungen der Halbleitervorrichtung sowie des Verfahrens ergeben sich aus den jeweils abhängigen Ansprüchen.

Für die Ausbildung eines guten Schottky-Kontakts ist es vorteilhaft, wenn das n-leitende erste Halbleitergebiet nur schwach dotiert ist. Günstigerweise liegt die Dotierstoffkonzentration deshalb höchstens bei 10¹⁷ cm⁻³, insbesondere bei höchstens 3·10¹⁶ cm⁻³. Die Höhe der Dotierstoffkonzentration bestimmt dabei maßgeblich die Sperrspannungsfestigkeit der Halbleitervorrichtung. So wird z.B. für eine Sperrspannung von bis zu 1200 V eine Dotierstoffkonzentration von 1.2·10¹⁶ cm⁻³ und für eine Sperrspannung von bis zu 3000 V eine Dotierstoffkonzentration von 3.6·10¹⁵ cm⁻³ gewählt.

Für einen guten ohmschen p-Kontakt ist es dagegen günstig, wenn das p-leitende zweite Halbleitergebiet zumindest im Grenzbereich zu der ohmschen p-Kontaktschicht eine ausreichend hohe Dotierstoffkonzentration aufweist. Bevorzugt liegt die Dotierstoffkonzentrationen zwischen 10¹⁷ cm⁻³ und 10²⁰ cm⁻³. Ein besonders guter ohmscher p-Kontakt ergibt sich, wenn die Dotierstoffkonzentration mindestens 10¹⁹ cm⁻³ beträgt. Die genannten Dotierstoffkonzentrationen lassen sich problemlos beispielsweise durch eine entsprechende Dotierstoffzugabe bei der epitaktischen Züchtung oder auch nachträglich mittels Ionenimplantation erzeugen.

In einer bevorzugten Ausführungsform ist das Aluminium mit einem Volumenanteil von mindestens 20% in dem Material enthalten. Als günstige Obergrenze hat sich ein Aluminiumvolumenanteil von höchstens 80% erwiesen. Besonders vorteilhaft ist ein Aluminiumvolumenanteil zwischen 40% und 50%. Ein Volumenanteil lässt sich auch dann ermitteln, wenn das Material als (intermetallische) Verbindung vorliegt. Maßgeblich für eine derartige Ermittlung sind dann die Atomradien der beteiligten Nickel- und Aluminium-Atome sowie ihre jeweilige Häufigkeit bezogen auf eine Einheitszelle. Gegebenenfalls kann auch zusätzlich der verringerte Atomabstand bei einer intermetallischen Verbindung mit berücksichtigt werden. Obwohl es aus Gründen einer möglichst effizienten Herstellung des ohmschen p-Kontakts und des Schottky-Kontakts günstiger ist, für beide Kontaktschichten eine identische Materialzusammensetzung vorzusehen, kann davon prinzipiell auch abgewichen werden. So ist z.B. in der Schottky-Kontaktschicht ein Aluminiumanteil von 50% und in der ohmschen p-Kontaktschicht ein Aluminiumanteil von 20% möglich.

Günstig ist es außerdem, wenn das Material nur aus Nickel und Aluminium besteht. In den Grenzbereichen liegt dann abgesehen von unvermeidbaren Verunreinigungen und den Dotierstoffatomen ein praktisch rein quarternäres Materialsystem aus den Einzelkomponenten Silicium und Kohlenstoff, die aus den SiC-Halbleitergebieten stammen, sowie Nickel und Aluminium, die aus dem Material der Kontaktschichten stammen, vor. Eine mögliche Beeinträchtigung des Kontaktverhaltens durch zusätzlich im Grenzbereich vorhandene Fremdatome, die die Austauschvorgänge im quarternären Materialsystem beeinflussen könnten, wird dann praktisch vollständig vermieden.

Bei einer bevorzugten Ausführungsvariante sind die beiden Kontaktschichten als eine zusammenhängende gemeinsame Kontaktschicht ausgebildet. Prinzipiell ist aber auch eine Ausführungsform, bei der die Schottky- und die p-Kontaktschicht voneinander getrennt sind, möglich.

Günstig ist außerdem eine Ausgestaltung, bei der beide Kontaktschichten einer Formierung bei mindestens 600°C unterzogen worden sind. Die solchermaßen formierten Kontaktschichten weisen dann einen besonders guten Schottky-Kontakt zum ersten Halbleitergebiet und einen besonders guten ohmschen Kontakt zum zweiten Halbleitergebiet auf.

Vorteilhafte Ausführungsformen des Verfahrens, die sich aus den entsprechenden Unteransprüchen ergeben, weisen im wesentlichen die gleichen Vorteile auf wie die obengenannten jeweils korrespondierenden Weiterbildungen der Halbleitervorrichtung.

Andere Ausbildungen des Verfahrens beziehen sich auf das Aufbringen des Materials auf das erste und zweite Halbleitergebiet.

Besonders vorteilhaft ist eine Ausbildung, bei der die beiden Kontaktschichten gleichzeitig hergestellt werden. Dadurch reduziert sich die Anzahl der im Vergleich zu einem sukzessiven Aufbringen benötigten Prozessschritte erheblich. Somit können kürzere Fertigungszyklen erreicht werden. Ein ansonsten gegebenenfalls erforderlicher Maskierungsschritt, kann dann ebenso entfallen, wie eine gesonderte Formierung beider Kontaktschichten. Vorteilhaft lassen sich beide Kontaktschichten ja gerade bei der gleichen Temperatur formieren, ohne dass die Qualität des Schottky-Kontakts dadurch maßgeblich leidet.

Dies wirkt sich auch bei der Ausführungsvariante günstig aus, bei der die beiden Kontaktschichten als eine zusammenhängende gemeinsame Kontaktschicht ausgebildet sind. Aufgrund der durch die speziellen Materialeigenschaften des Kontaktmaterials möglichen gemeinsamen Prozessierung, insbesondere der gemeinsamen Kontaktformierung des Schottky-Kontakts und des ohmschen p-Kontakts, lässt sich diese Ausführungsvariante dann nämlich besonders einfach herstellen.

Außerdem ist es für die Ausbildung sowohl eines guten Schottky-Kontaktverhaltens auf dem n-leitenden SiC als auch eines guten ohmschen Kontaktverhaltens auf dem p-leitenden SiC günstig, wenn die Kontaktschichten mit praktisch homogener, d.h. mit innerhalb der jeweiligen Kontaktschicht zumindest annähernd gleicher, Materialzusammensetzung auf den jeweiligen Halbleitergebieten vorliegen. Dies wird insbesondere dadurch erreicht, dass das Material nicht in Form eines Schichtaufbaus, sondern vielmehr direkt im endgültigen Mischungsverhältnis der beiden Hauptbestandteile Nickel und Aluminium auf die Halbleitergebiete aufgebracht wird. Bei Zusammensetzung des Materials aus mehreren Materialkomponenten wird durch einen solchen homogenen Materialauftrag erreicht, dass an der Grenzfläche zu den beiden Halbleitergebieten jeweils alle Materialkomponenten unmittelbar vorhanden sind und mit dem Siliciumcarbid der beiden Halbleitergebiete in Wechselwirkung treten können. Demgegenüber ist bei einem Schichtaufbau zunächst eine Durchmischung der separat z.B. mit einer Dicke in der Größenordnung einiger Nanometer aufgetragenen Nickel- und Aluminiumschichten erforderlich. Diese Durchmischung (= Homogenisierung) findet insbesondere zu Beginn eines nach dem Materialauftrag durchgeführten Temperprozesses statt. Der Temperprozess dient der Kontaktformierung. Für die Kontaktqualität sowohl des ohmschen p-Kontakts als auch des Schottky-Kontakts ist es nun von entscheidendem Vorteil, wenn bei dem Temperprozess bereits zu Beginn alle relevanten Materialkomponenten unmittelbar an der Grenzfläche zu den Halbleitergebieten vorhanden sind.

In einer weiteren Ausbildung des Verfahrens wird das Material, das auf die beiden Halbleitergebiete aufgebracht wird, mindestens zwei getrennten Quellen entnommen. Die Quellen enthalten dabei jeweils mindestens eine Materialkomponente, insbesondere Aluminium oder Nickel. Die Entnahme erfolgt durch gleichzeitiges Verdampfen oder Zerstäuben (Sputtern). Die beiden Kontaktschichten werden anschließend durch Abscheiden beider Materialkomponenten auf dem ersten und zweiten Halbleitergebiet gebildet. Das Material für die beiden Kontaktschichten entsteht dabei entweder noch in der Gasphase aus den einzelnen Materialkomponenten oder im Laufe des Abscheidevorgangs. Durch die Prozessparameter, wie beispielsweise eine entsprechende Plasma- oder Elektronenstrahlleistung, kann gewährleistet werden, dass ein bestimmtes beabsichtigtes Mischungsverhältnis eingehalten wird.

Eine alternative Ausbildung sieht dagegen vor, dass aus der ersten und zweiten Materialkomponente zunächst ein Quellmaterial hergestellt wird, das dann in einem zweiten Verfahrensschritt zerstäubt wird. Die herausgelösten Partikel des Materials bilden wie in der vorher beschriebenen Ausbildung die beiden Kontaktschichten auf dem n- und p-leitenden Siliciumcarbid.

In einer vorteilhaften Ausführungsvariante wird die Halbleitervorrichtung, nachdem die beiden Kontaktschichten aufgebracht worden sind, einem Temperprozess zur Kontaktformierung unterzogen. Bevorzugt wird die Halbleitervorrichtung dabei auf eine Formierungstemperatur von mindestens 600°C, insbesondere von etwa 1000°C, erhitzt und dann für bis zu 2 Stunden, insbesondere für 2 Minuten, auf etwa dieser Formierungstemperatur gehalten. Die Formierung kann auch nur aus einer Aufheizphase und einer unmittelbar folgenden Abkühlphase bestehen, ohne dass dazwischen eine Verweildauer bei einer Formierungstemperatur vorgesehen wird.

Bei einem anderen als dem hier verwendeten Nickel-Aluminium-Material würde die hohe Formierungstemperatur ab etwa 500°C zu einer Degradation und ggf. sogar zur kompletten Zerstörung des Schottky-Kontakts führen. Deshalb wird ein derzeit üblicher Schottky-Kontakt nur bei einer Temperatur von höchstens 400°C formiert. Bei einer so niedrigen Temperatur findet allerdings noch keine ausreichende Formierung des ohmschen p-Kontakts statt. Eine gleichzeitige Formierung beider Kontakte ist damit unmöglich.

Bei dem verwendeten Nickel-Aluminium-Material ergeben sich dagegen nach der beschriebenen gleichzeitigen Formierung sowohl auf dem n-leitenden SiC ein guter Schottky-Kontakt als auch auf dem p-leitenden SiC ein guter ohmscher p-Kontakt, die beide temperaturstabil sind.

Die zu kontaktierenden beiden Halbleitergebiete können aus α-SiC verschiedenen Polytyps bestehen. Insbesondere kann 6H-, 4H-, oder 15R-SiC verwendet werden. Besonders günstig ist der 4H-Polytyp. Andere als die genannten α-SiC-Polytypen sind jedoch ebenfalls möglich. Sowohl die Si- als auch die C-Seite des verwendeten α-SiC-Einkristalls können als Kontaktfläche für die Kontaktschichten verwendet werden. Besonders günstig ist jedoch die Si-Seite. Eine übliche Fehlorientierung mit einem Fehlwinkel von z.B. bis zu 10° ist in diesen Orientierungsangaben mit eingeschlossen.

Die Halbleitervorrichtung eignet sich besonders gut für einen Einsatz als schnelle Hochvoltdiode. Insbesondere kann mit der Halbleitervorrichtung eine Sperrspannung von ≥ 3 kV realisiert werden. Dies liegt an der mit dem verwendeten speziellen Nickel-Aluminium-Material erreichbaren hohen Schottky-Barriere von mehr als 1,5 eV. Günstig für eine Anwendung bei einer hohen Sperrspannung wirkt sich dabei insbesondere aus, dass die Schottky-Barriere im Sperrfall auch mit einer höheren Feldstärke belastbar ist als bei einer Halbleitervorrichtung mit einem anderen Kontaktmaterial für den Schottky-Kontakt.

Ausführungsbeispiele gemäß der Erfindung werden nunmehr anhand der Zeichnung näher erläutert. Zur Verdeutlichung ist die Zeichnung nicht maßstäblich ausgeführt und gewisse Merkmale sind schematisiert dargestellt. Im einzelnen zeigen:
- Figur 1: eine erste SiC-Halbleitervorrichtung mit einem Schottky-Kontakt und einem ohmschen p-Kontakt sowie
- Figur 2: eine zweite SiC-Halbleitervorrichtung mit einem Schottky-Kontakt und einem ohmschen p-Kontakt.

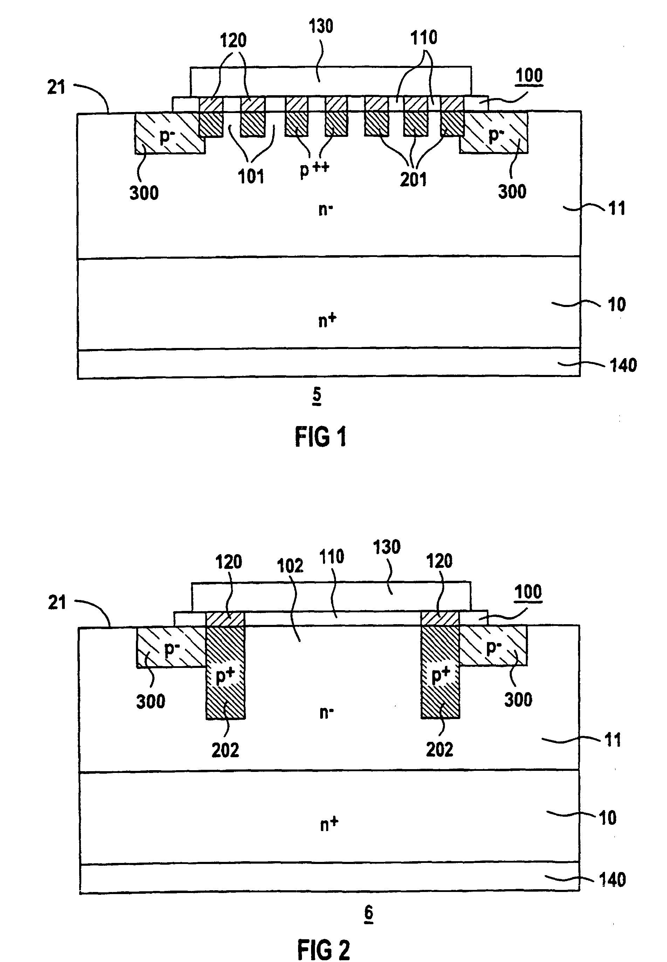

Einander entsprechende Teile sind in den Figuren 1 und 2 mit denselben Bezugszeichen versehen.

In Figur 1 ist eine Halbleitervorrichtung in Form einer in 4H-SiC realisierten Pinch-Diode 5 realisiert. Die Basis bildet ein stark n-leitendes 4H-SiC-Substrat 10 mit einer Dotierstoffkonzentration von 10¹⁹ cm⁻³, auf das eine schwach n-leitende 4H-SiC-Epitaxieschicht 11 mit einer Dotierstoffkonzentration von 10¹⁶ cm⁻³ aufgebracht ist. Als Dotierstoff für das n-leitende SiC dient jeweils Stickstoff. Die niedrige Dotierung der Epitaxieschicht 11 gewährleistet eine hohe Sperrfähigkeit und die hohe Dotierung des Substrats 10 einen niedrigen Durchlasswiderstand der Pinch-Diode 5. Die gezeigte Pinch-Diode 5 ist für eine Sperrspannung von bis zu 1200 V ausgelegt.

An einer von dem Substrat 10 abgewandten Oberfläche 21 der Epitaxieschicht 11 werden durch die Epitaxieschicht 11 gebildete erste Halbleitergebiete 101 jeweils durch eine Schottky-Kontaktschicht 110 kontaktiert. An der Oberfläche 21 sind außerdem mehrere stark p-dotierte zweite Halbleitergebiete 201 angeordnet, die sich mit den ersten Halbleitergebieten 101 abwechseln. Aluminium dient als Akzeptormaterial für die zweiten Halbleitergebiete 201, die eine Dotierstoffkonzentration von 10¹⁹ cm⁻³ aufweisen. Die zweiten Halbleitergebiete 201 sind jeweils durch eine ohmsche p-Kontaktschicht 120 kontaktiert.

Die in Figur 1 gezeigte Struktur mit abwechselnd angeordneten schwach dotierten n-leitenden ersten Halbleitergebieten 101 und stark dotierten p-leitenden zweiten Halbleitergebieten 202 ist typisch für eine Pinch-Diode. Die p-leitenden zweiten Halbleitergebiete 202 sorgen im Sperrfall für eine komplette Abschnürung der im Durchlassbetrieb für die Stromführung vorgesehenen ersten Halbleitergebiete 101, wodurch sich das Sperrvermögen erhöht.
An der Oberfläche 21 der Epitaxieschicht 11 sind damit in unmittelbarer Nachbarschaft erste und zweite Halbleitergebiete 101 bzw. 201 unterschiedlichen Leitungstyps angeordnet, die über einen Schottky-Kontakt bzw. über einen ohmschen p-Kontakt elektrisch kontaktiert sind. Aufgrund dieser unmittelbaren Nachbarschaft sind die Kontaktschichten 110 und 120 als eine zusammenhängende gemeinsame Kontaktschicht 100 ausgebildet. Die gemeinsame Kontaktschicht 100 besteht aus einem Material, das sich aus Aluminium und Nickel jeweils mit einem Volumenanteil von 50 % zusammensetzt. Es hat sich nämlich gezeigt, dass dieses spezielle Kontaktmaterial sowohl einen guten Schottky-Kontakt auf n-leitendem SiC als auch einen guten ohmschen p-Kontakt auf dem p-leitenden SiC bildet.

Die Kontaktschichten 110 und 120 sind gemeinsam in einem einzigen Herstellungsschritt auf die Oberfläche 21 aufgebracht worden und anschließend gemeinsam bei einer Temperatur von etwa 1000°C formiert worden. Aufgrund der besonderen Materialeigenschaften des Nickel-Aluminium-Materials kommt es bei dieser Formierung im Gegensatz zu anderen möglichen Kontaktwerkstoffen zu keiner Degradation des Schottky-Kontaktverhaltens. Die in Figur 1 gezeigte Pinch-Diode 5 lässt sich damit besonders einfach und preisgünstig herstellen. Insbesondere sind keine separaten Schutz- oder Reinigungsmaßnahmen für die Oberfläche 21 im Bereich der Schottky-Kontakte erforderlich.

In einem Randbereich sind die ersten und zweiten Halbleitergebiete 101 bzw. 201 zusätzlich durch ein schwach dotiertes drittes Halbleitergebiet 300 umgeben. Dieses dritte Halbleitergebiet 300 dient als Randabschluss und vermeidet insbesondere die Entstehung eines zu großen elektrischen Felds im Bereich der beiden Halbleitergebiete 101 bzw. 201. Ein solcher Randabschluss ist mit der *WO 96*/*03774* offenbart.

Die Kontaktschichten 110 bzw. 120 haben eine typische Dicke von etwa 200 nm. Auf ihrer von der Epitaxieschicht 11 abgewandten Oberfläche ist eine zusätzliche Kontaktverstärkungsschicht 130 aus Aluminium angeordnet. Auf einer von der Epitaxieschicht 11 abgewandten Seite des Substrats 10 befindet sich ein Rückseitenkontakt 140 aus Nickel. Die für den Rückseitenkontakt 140 aufgebrachte Nickel-Metallisierung wurde dabei insbesondere zusammen mit den Kontaktschichten 110 und 120 formiert. Damit erhält man über einen einzigen Formierungsschritt zusätzlich auch noch einen ohmschen Rückseitenkontakt. Alternativ zu dem Nickel kann für den Rückseitenkontakt 140 auch eine Nickel-Eisen(NiFe)-Legierung verwendet werden.

In Figur 2 ist als weitere Halbleitervorrichtung eine stoßstromfeste Schottky-Diode 6 dargestellt. Im Unterschied zu der Pinch-Diode 5 enthält die stoßstromfeste Schottky-Diode 6 keine Struktur, bei der sich an der Oberfläche 21 Halbleitergebiete mit entgegengesetztem Leitungstyp abwechseln. Statt dessen ist ein durch die Epitaxieschicht 11 gebildetes, wiederum schwach n-leitendes erstes Halbleitergebiet 102 durch ein stark p-dotiertes zweites Halbleitergebiet 202 umgeben. Vorausgesetzt ist hierbei ein rotationssymmetrischer Aufbau der in Figur 2 gezeigten Schottky-Diode 6.

Im Gegensatz zur Pinch-Diode 5 bewirkt die Schottky-Diode 6 keine Erhöhung des Sperrvermögens durch ein Abschnüren von stromtragenden Halbleitergebieten, sondern vielmehr eine Erhöhung der Stoßstromfestigkeit. Dazu übernimmt eine durch das zweite Halbleitergebiet 202 und das Substrat 10 gebildete p-n-Diode einen Teil eines Stoßstroms, der ansonsten komplett über den Schottky-Kontakt fließen und diesen gegebenenfalls überlasten würde. Durch die spezielle Dimensionierung schaltet sich diese p-n-Diode nur im Überlastfall, d.h. bei einem anstehenden hohen Stromimpuls, ein, wohingegen sie bei normalem Durchlassbetrieb stromlos bleibt, so dass der gesamte Strom in diesem normalen Betriebszustand über den Schottky-Kontakt fließt.

Die beschriebene Funktionsweise der Schottky-Diode 6 erfordert nun einen Schottky-Kontakt zum ersten Halbleitergebiet 102 und einen ohmschen p-Kontakt zu dem Halbleitergebiet 202. Wiederum liegen beide Kontakte unmittelbar benachbart zueinander. Wie im Ausführungsbeispiel von Figur 1 wird deshalb ein Nickel-Aluminium-Material als Kontaktwerkstoff für die Schottky-Kontaktschicht 110 und die ohmsche p-Kontaktschicht 120 verwendet. Auch hier resultiert dann eine zusammenhängende gemeinsame Kontaktschicht 100. Ihr Aluminiumanteil liegt bei diesem Ausführungsbeispiel bei 40 %, der Nickelanteil entsprechend bei 60 %.

## Patentansprüche

1. Halbleitervorrichtung aus Siliciumcarbid mit einem Schottky-Kontakt und einem ohmschen p-Kontakt umfassend mindestens
- ein erstes Halbleitergebiet (101, 102) aus n-leitendem Siliciumcarbid und ein zweites Halbleitergebiet (201, 202) aus p-leitendem Siliciumcarbid,
- eine Schottky-Kontaktschicht (110) und eine ohmsche p-Kontaktschicht (120), die das erste bzw zweite Halbleitergebiet elektrisch kontaktieren, die beide aus einem Material mit einer zumindest annähernd gesehen Zusammensetzung und mit mindestens zwei Materialkomponenten bestehen,
**dadurch gekennzeichnet, dass** das Material beider Kontaktschichten (110, 120) eine Zusammensetzung mit Nickel als erster Materialkomponente und Aluminium als zweiter Materialkomponente hat.

2. Halbleitervorrichtung nach Anspruch 1 **dadurch gekennzeichnet, dass** das erste Halbleitergebiet (101, 102) eine Dotierstoffkonzentration von höchstens 10¹⁷ cm⁻³ aufweist.

3. Halbleitervorrichtung nach Anspruch 1 oder 2, **dadurch gekennzeichnet, dass** das zweite Halbleitergebiet (201, 202) eine Dotierstoffkonzentration zwischen 10¹⁷ cm⁻³ und 10²⁰ cm⁻³ aufweist.

4. Halbleitervorrichtung nach einem der vorhergehenden Ansprüche **dadurch gekennzeichnet, dass** das Aluminium in dem Material mit einem Volumenanteil von mindestens 20 % enthalten ist.

5. Halbleitervorrichtung nach einem der vorhergehenden Ansprüche, **dadurch gekennzeichnet, dass** das Aluminium in dem Material mit einem Volumenanteil von höchstens 80 % enthalten ist.

6. Halbleitervorrichtung nach einem der vorhergehenden Ansprüche **dadurch gekennzeichnet, dass** die beiden Kontaktschichten (110, 120) als eine zusammenhängende gemeinsame Kontaktschicht (100) ausgebildet sind.

7. Halbleitervorrichtung nach einem der vorhergehenden Ansprüche, **dadurch gekennzeichnet, dass** beide Kontaktschichten (110, 120) als bei mindestens 600°C formierte Kontaktschichten (110, 120) ausgebildet sind.

8. Verfahren zur Herstellung einer Halbleitervorrichtung aus Siliciumcarbid mit einem Schottky-Kontakt und einem ohmschen p-Kontakt, mit folgenden Verfahrensschritten:
- es werden eine Schottky-Kontaktschicht (110) auf einem ersten Halbleitergebiet (101, 102) aus n-leitendem Siliciumcarbid und eine ohmsche p-Kontaktschicht (120) auf einem zweiten Halbleitergebiet (201, 202) aus p-leitendem Siliciumcarbid ausgebildet,
- für beide Kontaktschichten (110, 120) wird ein Material mit mindestens zwei Materialkomponenten aufgebracht, von denen Nickel eine erste Materialkomponente und Aluminium eine zweite Materialkomponente darstellen, die in den Kontaktschichten (110, 120) eine annähernd gleiche Materialzusammensetzung bilden.

9. Verfahren nach Anspruch 8, **dadurch gekennzeichnet, dass** für das erste Halbleitergebiet (101, 102) eine Dotierstoffkonzentration von höchstens 10¹⁷ cm⁻³ vorgesehen wird.

10. Verfahren nach Anspruch 8 oder 9, **dadurch gekennzeichnet, dass** für das zweite Halbleitergebiet (201, 202) eine Dotierstoffkonzentration zwischen 10¹⁷ cm⁻³ und 10²⁰ cm⁻³ vorgesehen wird.

11. Verfahren nach einem der Ansprüche 8 bis 10, **dadurch gekennzeichnet, dass** für das Aluminium in dem Material ein Volumenanteil von mindestens 20 % vorgesehen wird.

12. Verfahren nach einem der Ansprüche 8 bis 11, **dadurch gekennzeichnet, dass** für das Aluminium in dem Material ein Volumenanteil von höchstens 80% vorgesehen wird.

13. Verfahren nach einem der Ansprüche 8 bis 12, **dadurch gekennzeichnet, dass** die beiden Kontaktschichten (110, 120) gleichzeitig auf das erste und zweite Halbleitergebiet (101, 102, 201, 202) aufgebracht werden.

14. Verfahren nach einem der Ansprüche 8 bis 13, **dadurch gekennzeichnet, dass** das Material durch gleichzeitiges Verdampfen oder Zerstäuben aus zwei getrennten Quellen der ersten und zweiten Materialkomponente aufgebracht wird.

15. Verfahren nach einem der Ansprüche 8 bis 14, **dadurch gekennzeichnet, dass** ein Quellmaterial vorab aus der ersten und zweiten Materialkomponente hergestellt wird und das Material dann durch Zerstäuben des Quellmaterials aufgebracht wird.

16. Verfahren nach einem der Ansprüche 8 bis 15, **dadurch gekennzeichnet, dass** die die beiden Halbleitergebiete (101, 102, 201, 202) sowie die beiden aufgebrachten Kontaktschichten (110, 120) umfassende Halbleitervorrichtung einer Formierung mit einer Erhitzung auf eine Formierungstemperatur von mindestens 600°C, vorzugsweise von etwa 1000°C, unterzogen wird.

17. Verfahren nach Anspruch 16, **dadurch gekennzeichnet, dass** die Formierungstemperatur für eine Dauer von höchstens 2 Stunden, vorzugsweise von höchstens 2 Minuten, konstant gehalten wird.

## Claims

1. Semiconductor device made from silicon carbide, having a Schottky contact and an ohmic p-contact, comprising at least
- a first semiconductor region (101, 102) comprising n-conducting silicon carbide and a second semiconductor region (201, 202) comprising p-conducting silicon carbide,
- a Schottky contact layer (110) and an ohmic p-contact layer (120), which make electrical contact with the first semiconductor region and the second semiconductor region, respectively, and which both consist of a material which has an at least approximately identical composition and has at least two components, **characterized in that** the material of the two contact layers (110, 120) has a composition with nickel as first material component and aluminium as second material component.

2. Semiconductor device according to Claim 1, **characterized in that** the first semiconductor region (101, 102) has a dopant concentration of at most 10¹⁷ cm⁻³.

3. Semiconductor device according to Claim 1 or 2, **characterized in that** the second semiconductor region (201, 202) has a dopant concentration of between 10¹⁷ cm⁻³ and 10²⁰ cm⁻³.

4. Semiconductor device according to one of the preceding claims, **characterized in that** the material contains at least 20% by volume of aluminium.

5. Semiconductor device according to one of the preceding claims, **characterized in that** the material contains at most 80% by volume of aluminium.

6. Semiconductor device according to one of the preceding claims, **characterized in that** the two contact layers (110, 120) are formed as a cohesive common contact layer (100).

7. Semiconductor device according to one of the preceding claims, **characterized in that** the two contact layers (110, 120) are designed as contact layers (110, 120) which are annealed at at least 600°C.

8. Process for producing a semiconductor device made from silicon carbide, having a Schottky contact and an ohmic p-contact, comprising the following process steps:
- a Schottky contact layer (110) is formed on a first semiconductor region (101, 102) made from n-conducting silicon carbide, and an ohmic p-contact layer (120) is formed on a second semiconductor region (201, 202) made from p-conducting silicon carbide,
- a material with at least two components, of which nickel forms a first material component and aluminium forms a second material component, which form an approximately identical material composition in the contact layers (110, 120), is applied for both contact layers (110, 120).

9. Process according to Claim 8, **characterized in that** a dopant concentration of at most 10¹⁷ cm⁻³ is provided for the first semiconductor region (101, 102).

10. Process according to Claim 8 or 9, **characterized in that** a dopant concentration of between 10¹⁷ cm⁻³ and 10²⁰ cm⁻³ is provided for the second semiconductor region (201, 202).

11. Process according to one of Claims 8 to 10, **characterized in that** the aluminium forms at least 20% by volume of the material.

12. Process according to one of Claims 8 to 11, **characterized in that** the aluminium forms at most 80% by volume of the material.

13. Process according to one of Claims 8 to 12, **characterized in that** the two contact layers (110, 120) are applied simultaneously to the first and second semiconductor regions (101, 102, 201, 202).

14. Process according to one of Claims 8 to 13, **characterized in that** the material is applied by simultaneous vaporization or atomization from two separate sources of the first and second material components.

15. Process according to one of Claims 8 to 14, **characterized in that** a source material is prepared in advance from the first and second material components, and the material is then applied by atomization of the source material.

16. Process according to one of Claims 8 to 15, **characterized in that** the semiconductor device, which comprises the two semiconductor regions (101, 102, 201, 202) and the two applied contact layers (110, 120) is subjected to annealing involving heating at an annealing temperature of at least 600°C, preferably of approximately 1000°C.

17. Process according to Claim 16, **characterized in that** the annealing temperature is kept constant for a period of at most 2 hours, preferably of at most 2 minutes.

## Revendications

1. Dispositif à semi-conducteur en carbure de silicium ayant un contact de Schottky et un contact p ohmique, comprenant au moins
- une première zone (101, 102) semi-conductrice en carbure de silicium de conductivité n et une deuxième zone (201, 202) conductrice en carbure de silicium de conductivité p,
- une couche (110) de contact de Schottky et une couche (120) de contact p ohmique, qui sont en contact électriquement avec la première et la deuxième zone semi-conductrice, qui sont toutes deux en un matériau ayant au moins à peu près la même composition et qui sont constituées avec au moins deux constituants de matériau,
**caractérisé en ce que** le matériau des deux couches (110, 120) de contact a une composition ayant du nickel comme premier constituant du matériau et de l'aluminium comme deuxième constituant du matériau.

2. Dispositif à semi-conducteur suivant la revendication 1, **caractérisé en ce que** la première zone (101, 102) semi-conductrice a une concentration de dopage d'au plus 10¹⁷ cm⁻³.

3. Dispositif à semi-conducteur suivant la revendication 1 ou 2, **caractérisé en ce que** la deuxième zone (201, 202) semi-conductrice a une concentration de dopage comprise entre 10¹⁷ cm⁻³ et 10²⁰ cm⁻³.

4. Dispositif à semi-conducteur suivant l'une des revendications précédentes, **caractérisé en ce que** l'aluminium est contenu dans le matériau en une proportion en volume d'au moins 20 %.

5. Dispositif à semi-conducteur suivant l'une des revendications précédentes, **caractérisé en ce que** l'aluminium est contenu dans le matériau en une proportion en volume d'au plus 80 %.

6. Dispositif à semi-conducteur suivant l'une des revendications précédentes, **caractérisé en ce que** les deux couches (110, 120) de contact sont constituées sous la forme d'une couche (100) de contact commune d'un seul tenant.

7. Dispositif à semi-conducteur suivant l'une des revendications précédentes, **caractérisé en ce que** les deux couches (110, 120) de contact sont constituées sous la forme de couches (110, 120) de contact formées à au moins 600°C.

8. Procédé de fabrication d'un dispositif à semi-conducteur en carbure de silicium ayant un contact de Schottky et un contact p ohmique, comprenant les stades suivants :
- on forme une couche (110) de contact de Schottky sur une première zone (101, 102) semi-conductrice en carbure de silicium de conductivité n et une couche (120) de contact p ohmique sur une deuxième zone (201, 202) semi-conductrice en carbure de silicium de conductivité p,
- on dépose pour les deux couches (110, 120) de contact un matériau ayant au moins deux constituants de matériau, dont du nickel représente un premier constituant du matériau et de l'aluminium un deuxième constituant du matériau, qui forment dans les couches (110, 120) de contact une composition de matériau qui est à peu près la même.

9. Procédé suivant la revendication 8, **caractérisé en ce que** l'on prévoit, pour la première zone (101, 102) semi-conductrice, une concentration de substance de dopage d'au plus 10¹⁷ cm⁻³.

10. Procédé suivant la revendication 8 ou 9, **caractérisé en ce que** l'on prévoit, pour la deuxième zone (201, 202) semi-conductrice, une concentration de substance de dopage comprise entre 10¹⁷ cm⁻³ et 10²⁰ cm⁻³.

11. Procédé suivant l'une des revendications 8 à 10, **caractérisé en ce que** l'on prévoit, pour l'aluminium dans le matériau, une proportion en volume d'au moins 20 %.

12. Procédé suivant l'une des revendications 8 à 11, **caractérisé en ce que** l'on prévoit, pour l'aluminium dans le matériau, une proportion en volume d'au plus 80 %.

13. Procédé suivant l'une des revendications 8 à 12, **caractérisé en ce que** l'on dépose les deux couches (110, 120) de contact en même temps sur la première et sur la deuxième zone (101, 102, 201, 202) semi-conductrice.

14. Procédé suivant l'une des revendications 8 à 13, **caractérisé en ce que** l'on dépose le matériau par évaporation ou pulvérisation simultanée à partir de deux sources distinctes des premier et deuxième constituants du matériau.

15. Procédé suivant l'une des revendications 8 à 14, **caractérisé en ce que** l'on produit d'abord un matériau de source à partir des premier et deuxième constituants du matériau et on dépose ensuite le matériau par pulvérisation du matériau de source.

16. Procédé suivant l'une des revendications 8 à 15, **caractérisé en ce que** l'on soumet le dispositif à semi-conducteur comprenant les deux zones (101, 102, 201, 202) semi-conductrices ainsi que les deux couches (110, 120) de contact déposées à un formage par un chauffage jusqu'à une température de formage d'au moins 600°C, de préférence d'environ 1000°C.

17. Procédé suivant la revendication 16, **caractérisé en ce que** l'on maintient constante la température de formage pendant une durée d'au plus deux heures, de préférence d'au plus deux minutes.
